# EUROPEAN PATENT SPECIFICATION

(11) **EP 3 874 206 B1**
(45) Date of publication and mention of the grant of the patent: **11.12.2024**
(21) Application number: 19828284.0
(22) Date of filing: 29.10.2019
(51) Int. Cl.: F24C 7/08, G01R 29/08, H05B 6/06

(54) **METHOD AND ARRANGEMENT FOR RECOGNIZING A STOVE TYPE**
VERFAHREN UND ANORDNUNG ZUR ERKENNUNG EINES KOCHFELDTYPS
PROCÉDÉ ET AGENCEMENT POUR RECONNAÎTRE UN TYPE DE TABLE DE CUISSON

(30) Priority: 30.10.2018 FI 20185911
(43) Date of publication of application: 08.09.2021
(73) Proprietor: Safera OY, 02150 Espoo (FI)
(72) Inventor: LINTONEN, Samuli, 01520 Vantaa (FI); PÄLVILÄ, Tuomo, 04410 Järvenpää (FI)
(74) Representative: Papula Oy
(86) International application number: PCT/FI2019/050771
(87) International publication number: WO 2020/089526

(56) References cited:
- EP-A1- 2 562 480
- EP-A2- 1 962 408
- DE-A1- 19 636 277
- JP-A- 2009 293 933
- JP-A- 2011 100 562
- US-A1- 2013 255 661

## Description

### FIELD OF THE INVENTION

The invention relates to stove guards for improving stove safety and usability. Specifically, the invention relates to ways for the stove guard to recognize a stove type.

### BACKGROUND OF THE INVENTION

An essential purpose of a stove guard is to observe when normal stove use has changed to a dangerous situation or a risk of one. For making observations, the stove guard is provided with one or more sensors, which are arranged to detect events on the stove and in the surrounding area. Known sensor types are for example infrared receivers, motion detectors, smoke detectors, hygrometers, etc.

The operating and dangerous situations relating to a stove may be different and develop in different ways depending on the stove type. Particularly different from the other stove types is the induction stove. With the induction stove, heating of a cooking vessel and its content is not based on conduction of heat from a cooking plate of the stove to the vessel but on induced electric currents in the base material of the vessel. This difference is critical in terms of what kinds of situations may develop and how quickly the situations on the stove would change.

For example, the ignition of paper and an oil fire could be considered to compare the development of dangerous situations with different stove types. If a sheet of paper or a paper napkin has been forgotten on a stove with cast iron or ceramic cooking plates and the stove is switched on, the paper may catch fire when the cooking plate has become sufficiently hot, while there is no such danger with the induction stove. However, if there is a pot on the stove with some oil in it, the induction stove may heat them up to the oil flaming point in less than one and a half minutes, whereas with a cast iron or ceramic stove it would typically take several minutes to reach the corresponding dangerous situation.

If the stove guard is not a component manufactured or integrated to the stove by the stove manufacturer, but is instead an accessory installed for example at the extractor hood or elsewhere in the vicinity of the stove, in principle it does not know what stove type it is monitoring. The recognition of device types will certainly be facilitated in the future, if it can be assumed that any home appliance will at some point come with a Bluetooth chip or corresponding wireless data transfer means. The intelligent and data transfer capable devices may then easily exchange various data with each other.

However, before this future scenario becomes a reality, it would be advantageous if the stove guard could independently recognize the stove type. On the basis of the recognized stove type it would be possible for the stove guard to adjust its operations so as to serve the use of that specific stove type in the best possible way.

Patent publication US 2017/0324487 A1 discloses a procedure for arranging wireless communication between kitchen appliances. The publication discusses e.g. ensuring that the strength of a signal received by a stove or other corresponding device is sufficient.

Patent publication JP 2012178300 A discloses a stove guard which is able to recognize a situation where a pan or a corresponding cooking vessel is heated in an abnormal way due to warping of the base.

Patent publication US 2013/0037535 discloses an induction stove which is able to reliably detect food boiling over. The detecting is based on a capacitive detector measuring a change in capacitance caused by the food boiling over.

Patent publication US 2015/0257576 A1 discloses a cooking vessel designed to be used on an induction stove, the vessel itself being provided with electronic control functions. The operating energy required for the functions is taken inductively from the energy with which the induction stove heats up the cooking vessel.

Patent publication US 2016/0281995 A1 discloses a device, the purpose of which is to provide for a user an indication of heating of a stove on the basis of the stove's measured operating current. The current measuring unit and the indicator device communicate wirelessly with each other.

Patent publication US 2013/255661 A1 discloses an extractor hood capable to identify the type of cooker based on a cooker signal.

### SUMMARY OF THE INVENTION

An object of the invention is to introduce a stove guard arrangement which is able to recognize at least an induction stove. An object of the invention is specifically that the recognition of the induction stove may be performed regardless of the location or distance of installation of the stove guard in relation to the stove. Additionally, an object of the invention is that the recognition of the induction stove may be performed without significant need for additional space or power in the stove guard arrangement. Further, an object of the invention is that the recognition of the induction stove may be carried out with affordable and operationally reliable components.

The objects of the invention are achieved by using the typical electromagnetic effects caused by stove operation to recognize the stove type.

The stove guard arrangement according to the invention is characterized by the features set forth in the characterizing part of the accompanying independent claim relating to the stove guard arrangement. Preferred embodiments and additional features of the invention are set forth in the dependent claims.

The stove guard arrangement according to the invention comprises a receiver connected to a processing component of the stove guard arrangement. The receiver is arranged to receive radio-frequency interference and to provide corresponding reception data. The processing component is arranged to recognize regular changes in said reception data and to derive, on the basis of the recognized regular changes, a conclusion that the stove is an induction stove.

A method according to the invention comprises receiving radio-frequency interference in the vicinity of a stove and forming corresponding reception data. The method comprises recognizing one or more regular changes in said reception data and concluding from the recognized regular changes that said stove is an induction stove.

It is possible to distribute many of the functions described above among the actual stove guard component and another device used by the user, so as to achieve even better operating convenience and adaptability to different operating environments and situations.

The advantages and application possibilities of the invention are illustrated more specifically in the detailed description of the embodiments and the accompanying figures.

### LIST OF FIGURES

**Fig. 1** illustrates a stove guard arrangement according to the prior art,
**Fig. 2** illustrates a stove guard arrangement according to one embodiment of the invention,
**Fig. 3** shows some preferred couplings for use in a stove guard arrangement according to the invention,
**Fig. 4** illustrates a stove guard arrangement according to one embodiment of the invention, and
**Fig. 5** illustrates a method according to one embodiment of the invention.

### DETAILED DESCRIPTION OF THE INVENTION

In this text a stove guard arrangement refers to a technical device or an ensemble of two or more technical devices interacting with each other, the operation of which includes detecting events on a stove and reacting to exceptional events on the stove so as to reduce or prevent danger. The operation of the stove guard arrangement may also comprise presenting data to a user for events that occurred some time ago on the stove.

If the stove guard arrangement includes two or more devices, at least one of them may be the actual stove guard component to be installed in the stove surrounding area, and at least one other device may be a portable user device. There may be two or more components to be installed in the stove surrounding area, for example such that one of them is a sensor unit to be installed at least partly in view, including at least some of the sensors of the stove guard arrangement, while another one is a control and power switch-off unit to be installed over the current supply path for the stove. The portable user device may be, for example, a smart phone, a smart watch, a tablet computer, a portable computer, or another device that is easily portable by the user. The user device may also be a user interface based on voice control, such as a smart speaker. The stove guard arrangement may also comprise components of other smart home electronic devices.

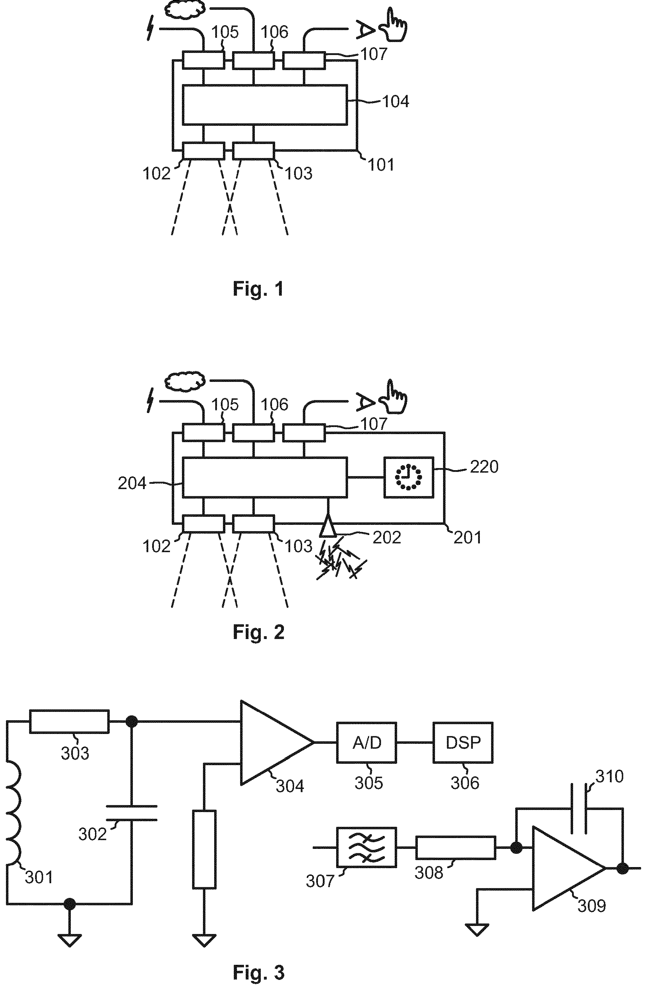

Fig. 1 schematically illustrates one stove guard arrangement 101 according to the prior art with sensors 102 and 103 for detecting events on a stove and for providing detection data. In this example, two sensors are presented, but there may be some other number of sensors, for example one, three or more. The sensors may be of the same type and detect the same event, for example in a way that the only difference involves direction of the sensors. It is also possible that the stove guard arrangement includes two or more different types of sensors, which may detect quite different events. Known sensor types are for example infrared receivers, motion detectors, smoke detectors, hygrometers, etc.

In this text, detection data refer to electrical signals provided by the sensor 102 or 103 in response to some observation that the sensor is configured to make. For example, in case of a simple sensor for receiving infrared radiation from a specific area, the detection data may be for example continuous or periodic analogue or digital signals indicating how much infrared radiation the sensor receives at a given time. The detection data may also be of a yes/no type, i.e. the data may only indicate whether the amount of infrared radiation instantaneously received by the sensor is greater or smaller than some threshold value determined by the structure of the sensor. The sensor may provide detection data continuously or regularly or only when separately requested. Different sensors may provide very different types of detection data.

The stove guard arrangement 101 includes a programmable processing component 104 for analysing the above-mentioned detection data and for providing exceptional situation data in response to the detection data indicating some exceptional situation defined in the programming of the processing component 104. A simplified example of an exceptional situation could be that, according to the detection data provided by a sensor receiving infrared radiation, the amount of infrared radiation as received has increased to an exceptional level (i.e. some region in the stove area is significantly hotter than normally). In practice, diverse techniques for analysing the detection data and for detecting exceptional situations may be defined in the programming of the processing component 104. These techniques may include for instance learning, artificial intelligence based reasoning processes, which compare observations at a specific point of time and the detection history preceding the observations with previous corresponding events in order to conclude when the development of the detection data indicates that everything is no longer as it should be in the stove area.

In this text, exceptional situation data refer to electrical signals provided by the processing component 104, indicating that according to an analysis made by the processing component 104, the detection data received from the sensors 102 and 103 indicate an exceptional situation. If, according to the analysis made by the processing component 104, the exceptional situation is minor and does not require immediate action, the processing component 104 may accept to store the exceptional situation data in some available memory, typically together with additional data such as a time and a date. If the exceptional situation is one that has been defined as requiring action in the programming of the processing component 104, the processing component 104 may, in addition to or instead of storage, submit the exceptional situation data further through a suitable interface. Fig. 1 presents as examples an electrical system interface 105, a data transfer interface 106 and a user interface 107.

The electrical system interface 105 is an interface via which the stove guard arrangement 101 may control the distribution of electricity in the stove area. It may include for example a relay that may be used for switching off the supply of electricity. It may also include a control transmitter capable of converting the exceptional situation data provided by the processing component 104 to a control command and transmitting it to a relay or other switch of the electrical system.

The data transfer interface 106 is an interface via which the stove guard arrangement 101 may exchange data between other data processing capable devices for example in the home IoT network (internet of things) or over short range wireless peer-to-peer connections. The user interface 107 is an interface via which the stove guard arrangement 101 may give notifications and suggestions to a user, and via which it may receive commands from the user for example in the form of pushing a button or voice commands. The notifications given to the user via the user interface 107 may be for example indicator lights being turned on, indicator sounds, synthesized speech, symbols or text displayed on a screen or other such notifications.

One operating model of the prior art stove guard arrangement presented in Fig. 1 may be for example one wherein, when the processing component 104 has detected an exceptional situation, it notifies the user via the user interface 107 with an indicator sound and light. It is then up to the user to react to the received notification for example by turning down the power for one of the hotplates of the stove, which the user does by turning a knob, pressing a button, touching a touch sensitive switch or using some other device via which the user gives control commands to the stove. The stove receives the control command given by the user and turns down the power for the hotplate accordingly. The user may also give a confirmation to the stove guard arrangement via the user interface 107.

Fig. 2 schematically illustrates a stove guard arrangement according to one embodiment of the invention. It is similar to the embodiment of Fig. 1 in that the stove guard arrangement of Fig. 2 also includes sensors 102 and 103 for detecting events on a stove and for providing detection data, and a programmable processing component 204 for analysing the detection data and for providing exceptional situation data in response to the detection data indicating an exceptional situation defined in the programming of the processing component 204. Common features are also an electrical system interface 105, data transfer interface 106 and user interface 107.

A stove guard arrangement 201 of Fig. 2 differs from the stove guard arrangement of Fig. 1 in that it comprises a receiver 202, which is connected to the processing component 204 and arranged to receive radio-frequency interference and to provide corresponding reception data. Radio-frequency interference refers to electromagnetic oscillating effects at frequencies of at least several kilohertz, which are not generated on purpose for example for data transfer needs. Radio-frequency interference may appear in a conductive body or a conductor, in which case it is referred to as conducted radio-frequency interference. Radio-frequency interference may also propagate wirelessly, in which case it is coupled to electronic circuits and conductive bodies serving as reception antennas via electromagnetic induction and/or electrostatic coupling.

The reception data refer to signals provided by the receiver 202, which are unambiguously associated to the amount and/or quality of the received radio-frequency interference. The idea is that the reception data provided by the receiver 202 vary according to the type of the radio-frequency interference it has received. From this interference it is possible to recognize the reception of radio-frequency interference originating with high probability from a nearby induction stove.

The induction stove differs significantly from a stove with cast iron or ceramic cooking plates in terms of the load to which electric current is directed to heat up a cooking vessel. With a stove comprising cast iron or ceramic cooking plates the load is almost entirely resistive, whereas with the induction stove the load exhibits significant reactivity. Directing an electric current to a reactive load generates more and different types of radio-frequency interference than directing a current to a resistive load. Receiving this type of radio-frequency interference resulting from the activity of an induction stove by the receiver 202 provides specific type of reception data. Because the functions of an induction stove are switched from time to time on and off, the reception data provided by the receiver 202 indicate corresponding regular changes. Regular changes may also mean other changes caused by the operation of an induction stove: the stove may for example automatically turn up or down the power for a specific cooking area according to some programmed routine. The processing component 204 is arranged to recognize regular changes in the reception data and derive, on the basis of the recognized regular changes, a conclusion that the stove being monitored by the stove guard arrangement is an induction stove.

Using wirelessly propagated radio-frequency interference to recognize an induction stove is advantageous in that there are not much special requirements for the location of the reception device in the vicinity of the stove. Wirelessly propagated radio-frequency interference propagates in all directions in the stove surroundings and couples at least with some strength to almost any electronic circuit that is not specifically protected against radio-frequency interference.

In order for the receiver 202 to provide clearly detectable and recognizable reception data on radio-frequency interference caused specifically by an induction stove, it is advantageous if the receiver is configured to receive this type of interference with particular efficiency. In the research for the invention it has been found that a particularly advantageous receiver comprises an oscillating circuit with a primary resonance frequency, i.e. fundamental frequency, of tens or hundreds of kilohertz, most preferably 30 kHz - 120 kHz. Fig. 3 presents some configurations to be used in this type of an oscillating circuit.

Fig. 3 shows on the left an oscillating circuit with an inductive component, i.e. a coil 301, a capacitive component, i.e. a capacitor 302, and a resistor 303. This circuit may be referred to as an LC or LCR resonance circuit depending on the degree of resistance of the resistor 303. The looped resonance circuit as presented in Fig. 3 is not the only possible alternative, as the inductive, capacitive and possible resistive components of the resonance circuit may also form a linear or other type of circuit topology.

The oscillating circuit is connected to a detection coupling comprising successively in the signal propagating direction an amplifier, an A/D converter and a digital processing unit. The oscillating signal induced in the resonance circuit is conducted via an operational amplifier coupling 304 to an A/D converter 305, the sampling frequency of which is sufficiently high to obtain representative samples. According to a known sampling theorem, a sampling frequency must be at least double the highest frequency of the original signal, the presence of which in the sampled digital signal should be evaluable. A digital processing unit 306 may calculate from the sampled signal for example a Fourier transform or some other mapping that may be used for the detection of periodic changes. The Fourier transform or the like may for example be used to recognize a regular appearance and disappearance of an oscillating frequency which typically results from an induction stove.

In the distribution of the functions of the stove guard arrangement, the amplifier 304, A/D converter 305 and digital processing unit 306 may be for example part of the processing component 204, in which case the reception data refer to signals induced in the oscillating circuit directly. Alternatively the detection coupling may be, fully or partly, part of the receiver 202, in which case the reception data obtained by the processing component 204 may already be quite far processed at the processing component 204. Also other configurations between these two alternatives are possible.

The use of the A/D converter 305 and digital processing unit 306 provides the advantage that even relatively complicated analyses of the signals induced in the oscillating circuit are possible. However, the A/D conversion at a frequency of several hundred kilohertz and the detection of periodic changes from the analysis results may in some cases consume too much of the resources of the stove guard arrangement. Fig. 3 presents at bottom right an alternative, simpler coupling to be connected to the output of the amplifier 304. In this alternative configuration the detection coupling connected to the oscillating circuit consists of an amplifier, a band-pass filter, a rectifier and an integrator connected successively in the signal propagating direction. Among these elements, the rectifier and the integrator are in the alternative configuration of Fig. 3 implemented using a rectifying integrator coupling comprising a shunt resistor 308, an operational amplifier 309 and its primarily capacitive feedback coupling 310. The signal at the integrator output is proportional to the amount of energy of the frequency band according to the pass band of the band-pass filter 307.

It is advantageous if the components of the oscillating circuit are structurally and functionally such that the oscillating circuit receives radio-frequency interference as efficiently as possible at the frequencies generated by the induction stove. In addition, the components of the oscillating circuit should be small in size, affordable in manufacturing costs and easily usable on automated electronic device assembly lines. In the research for the invention it was found that a particularly advantageous inductive component for the oscillating circuit is a solid-cored coil arranged on a circuit board as a surface-mounted component. Such coils are used as inductive components in oscillating circuits for example in remote controllers for vehicle locking systems, so due to their general use they are relatively affordably available in sufficiently large batches from many different sources.

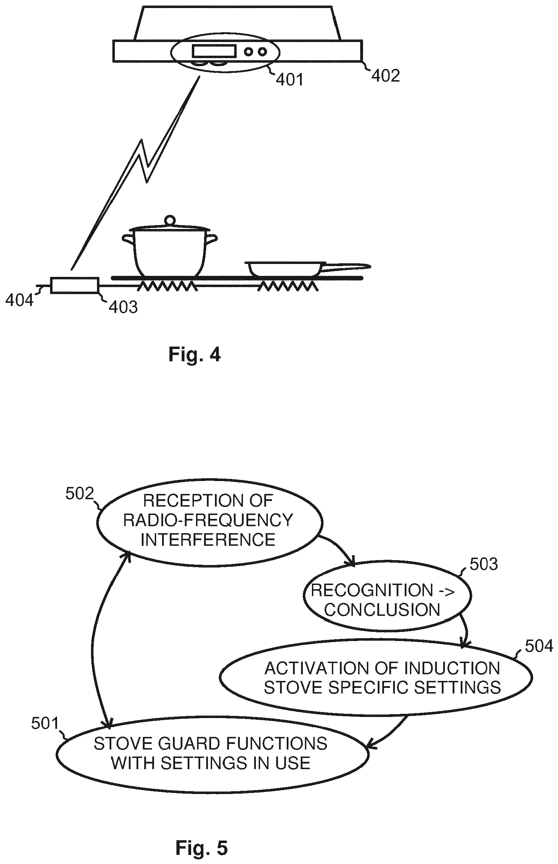

In addition to or instead of wirelessly propagated radio-frequency interference, the receiver of the stove guard arrangement may be arranged to receive conducted radio-frequency interference from a stove current supply line. This principle is illustrated in Fig. 4, where a sensor unit 401 of the stove guard arrangement is integrated to an extractor hood 402. The stove guard arrangement also comprises a control and power switch-off unit 403, which is connected to a stove current supply line 404. In the embodiment of Fig. 4 there is a wireless data transfer connection between the sensor unit 401 and the control and power switch-off unit 403, but additionally or instead a wired connection could also be used.

When a part of the induction stove is operating, conducted radio-frequency interference appears in the current supply line 404. As a result, the alternating current in the current supply line is not regularly sinusoidal but shows alterations that may be referred to for example as multiples, harmonic frequencies, breaks, phase errors and/or distortion. A receiver connected to the stove current supply line 404, located for example at the control and power switch-off unit 403, may be arranged to receive these alterations to provide a reception signal used for the same purpose as described above in connection with the receiver receiving wirelessly propagated radio-frequency interference. The use of conducted radio-frequency interference to recognize an induction stove provides the advantage that because the interference is received from the supply line which is immediately connected to the stove, it is in very clear and unambiguous association with the operation of a stove part.

The recognition of an induction stove on the basis of the reception of radio-frequency interference can be supported with signals provided by other sensors of the stove guard arrangement. When the cooking plate of an induction stove is switched on, it starts to provide radio-frequency interference. At the same time, any object placed on the cooking plate, if it conducts electricity in a proper way, starts to heat up rapidly. Correspondingly, when the cooking plate of an induction stove is switched off, the radio-frequency interference caused during the operation stops, and the pot or other object on the plate stops heating. The processing component 204 may be arranged to derive the above-described conclusion (i.e. recognizing an induction stove) in response to detecting that a specific regular change in the reception data that describes the radio-frequency interference occurs simultaneously with detection data according to which at least one of the sensors of the stove guard arrangement has detected a sudden increase or decrease in temperature.

Fig. 5 schematically illustrates a method according to one embodiment of the invention as a state diagram. State 501 is a normal state where the stove guard arrangement operates using settings which the user has defined to be used and/or which are in use due to preprogramming and automatics controlling the operation of the stove guard arrangement. In particular when the stove guard is switched on for the first time or has been switched off for a long time, it may simultaneously or varyingly receive radio-frequency interference in the vicinity of the stove so as to form corresponding reception data according to state 502. If one or more regular changes are recognized from the reception data according to state 503, it may be concluded that there is an induction stove in the vicinity of the stove guard arrangement.

State 504 describes one possible operation that the recognition of the stove as an induction stove may trigger. According to state 504, when it is recognized that the stove is an induction stove, at least one induction stove specific setting may be activated in order to adjust the operation of the stove guard. As stated above, a typical feature in the operation of an induction stove is that the temperature increases faster than with a stove comprising cast iron or ceramic cooking plates. Therefore, said induction stove specific setting to adjust the operation of the stove guard may be for example an exceptional situation dependent on the increase of temperature, matched to the operation of an induction stove. The stove guard arrangement may thus be arranged to interpret that specific detection data supplied by the sensors indicate an exceptional situation relating to the increase of temperature as defined in the programming of the stove guard arrangement, and this interpretation may be more readily or more quickly made if the stove has been recognized as an induction stove.

Another example of an induction stove specific setting to adjust the operation of the stove guard is a delay between detecting an exceptional situation and switching off some part of the stove. The stove guard arrangement may be arranged to wait for a shorter time before switch-off if the stove has been recognized as an induction stove. This is because, as described above, with an induction stove the situation may develop at least in some cases to a dangerous one faster than with a stove comprising cast iron or ceramic cooking plates.

For clarity and simplicity, the stove guard arrangement has been described above as a separate device or an ensemble of devices including all of the above-described functionalities. The invention is, however, similarly applicable to a stove guard arrangement forming an integrated part of the structure of some other device. Such other device may be for example an extractor hood or a light fixture. In some cases the stove guard arrangement may also be integrated to the stove itself and/or to an extractor hood.

The above disclosure has focused on specifically describing stove guard arrangements the components of which are installed in the vicinity of a stove. It should be noted that a significant portion of the above-described functionalities of different components of the stove guard arrangement may also be implemented in other ways, using for example cloud processing and storage resources and/or a portable user terminal. In particular the processing component for analysing the detection data and providing the exceptional situation data may be fully or partly located elsewhere than at components installed in the vicinity of the stove, for example in the cloud or as part of a portable user device. In such a configuration, connecting the other components to the processing component means establishing the connections indirectly, i.e. arranging a sufficiently efficient data transfer connection between the components.

## Claims

1. A stove guard arrangement, comprising
- sensors (102, 103) for detecting events on a stove and for providing detection data, and
- a programmable processing component (204) for analysing the detection data and for providing exceptional situation data in response to the detection data indicating an exceptional situation defined in the programming of the processing component (204);
**characterized in that**
- the stove guard arrangement comprises a receiver (202) connected to the processing component (204) and arranged to receive radio-frequency interference and to provide corresponding reception data,
- the processing component (204) is arranged to recognize regular changes in said reception data and to derive, on the basis of the recognized regular changes, a conclusion that the stove is an induction stove.

2. The stove guard arrangement according to claim 1, **characterized in that** said receiver (202) is arranged to receive wirelessly propagated radio-frequency interference.

3. The stove guard arrangement according to claim 2, **characterized in that** the receiver comprises an oscillating circuit (301, 302, 303) with a primary resonance frequency of tens or hundreds of kilohertz, most preferably 30 - 120 kHz.

4. The stove guard arrangement according to claim 3, **characterized in that** said oscillating circuit (301, 302, 303) comprises as an inductive component (301) a solid-cored coil arranged on a circuit board as a surface-mounted component.

5. The stove guard arrangement according to claim 3 or 4, **characterized in that** it comprises a detection coupling (304, 305, 306) connected to the oscillating circuit and comprising successively in the signal propagating direction an amplifier (304), an A/D converter (305) and a digital processing unit (306) .

6. The stove guard arrangement according to claim 3 or 4, **characterized in that** it comprises a detection coupling (304, 307, 308, 309, 310) connected to the oscillating circuit and comprising successively in the signal propagating direction an amplifier (304), a band-pass filter (307), a rectifier and an integrator (308, 309, 310).

7. The stove guard arrangement according to any of the preceding claims, **characterized in that** said receiver (202) is arranged to receive conducted radio-frequency interference from the stove current supply line.

8. The stove guard arrangement according to any of the preceding claims, **characterized in that** the processing component (204) is arranged to derive said conclusion in response to detecting that a specific regular change in said reception data occurs simultaneously with detection data according to which at least one of said sensors has detected a sudden increase or decrease in temperature.

9. A method for recognizing a stove type, **characterized in that** it comprises
- receiving (502) radio-frequency interference in the vicinity of a stove and forming corresponding reception data,
- recognizing (503) one or more regular changes in said reception data, and
- concluding (503) from the recognized regular changes that said stove is an induction stove.

10. The method according to claim 9, **characterized in that** it comprises receiving (502) wirelessly propagated radio-frequency interference with a primary resonance frequency of tens or hundreds of kilohertz, most preferably 30 - 120 kHz.

11. The method according to claim 9 or 10, **characterized in that** it comprises concluding (503) from the recognized regular changes that said stove is an induction stove, if a specific regular change occurs simultaneously with a sudden increase or decrease in temperature as detected by sensors of a stove guard arrangement.

12. The method according to any of claims 9-11, **characterized in that** when it is recognized (503) that said stove is an induction stove, at least one induction stove specific setting is activated (504) in order to adjust the operation of the stove guard.

13. The method according to claim 12, **characterized in that** said setting is at least one of the following: exceptional situation dependent on temperature increase, matched to the operation of an induction stove; delay between detecting an exceptional situation and switching off some part of the stove.

## Patentansprüche

1. Herdüberwachungsanordnung, umfassend
- Sensoren (102, 103) zum Erfassen von Ereignissen auf einem Herd und zum Bereitstellen von Erfassungsdaten, und
- eine programmierbare Verarbeitungskomponente (204) zum Analysieren der Erfassungsdaten und zum Bereitstellen von Ausnahmesituationsdaten in Reaktion auf die Erfassungsdaten, die eine in der Programmierung der Verarbeitungskomponente (204) definierte Ausnahmesituation anzeigen;
**dadurch gekennzeichnet, dass**
- die Herdüberwachungsanordnung einen Empfänger (202) umfasst, der mit der Verarbeitungskomponente (204) verbunden und so angeordnet ist, dass er Hochfrequenzstörungen bzw. Radiofrequenzinterferenzen empfängt und entsprechende Empfangsdaten bereitstellt,
- die Verarbeitungskomponente (204) so angeordnet ist, dass sie regelmäßige Änderungen in den Empfangsdaten erkennt und auf der Grundlage der erkannten regelmäßigen Änderungen eine Schlussfolgerung ableitet, dass der Herd ein Induktionsherd ist.

2. Herdüberwachungsanordnung nach Anspruch 1, **dadurch gekennzeichnet, dass** der Empfänger (202) so eingerichtet ist, dass er drahtlos übertragene Hochfrequenzstörungen empfängt.

3. Herdüberwachungsanordnung nach Anspruch 2, **dadurch gekennzeichnet, dass** der Empfänger einen Schwingkreis (301, 302, 303) mit einer primären Resonanzfrequenz von einigen zehn oder hundert Kilohertz, vorzugsweise 30 - 120 kHz, umfasst.

4. Herdüberwachungsanordnung nach Anspruch 3, **dadurch gekennzeichnet, dass** der Schwingkreis (301, 302, 303) als induktives Bauelement (301) eine Vollkernspule umfasst, die als oberflächenmontiertes Bauelement auf einer Leiterplatte angeordnet ist.

5. Herdüberwachungsanordnung nach Anspruch 3 oder 4, **dadurch gekennzeichnet, dass** sie eine mit dem Schwingkreis verbundene Detektionskopplung (304, 305, 306) umfasst, die in Signalausbreitungsrichtung nacheinander einen Verstärker (304), einen A/D-Wandler (305) und eine digitale Verarbeitungseinheit (306) aufweist.

6. Herdüberwachungsanordnung nach Anspruch 3 oder 4, **dadurch gekennzeichnet, dass** sie eine mit dem Schwingkreis verbundene Detektionskopplung (304, 307, 308, 309, 310) umfasst, die in Signalausbreitungsrichtung nacheinander einen Verstärker (304), ein Bandpassfilter (307), einen Gleichrichter und einen Integrator (308, 309, 310) umfasst.

7. Herdüberwachungsanordnung nach einem der vorhergehenden Ansprüche, **dadurch gekennzeichnet, dass** der Empfänger (202) so angeordnet ist, dass er leitungsgebundene Hochfrequenzstörungen von der Herdstromversorgungsleitung empfängt.

8. Herdüberwachungsanordnung nach einem der vorhergehenden Ansprüche, **dadurch gekennzeichnet, dass** die Verarbeitungskomponente (204) so eingerichtet ist, dass sie die Schlussfolgerung als Reaktion auf die Feststellung ableitet, dass eine bestimmte regelmäßige Änderung in den Empfangsdaten gleichzeitig mit Erfassungsdaten auftritt, denen zufolge mindestens einer der Sensoren einen plötzlichen Temperaturanstieg oder -abfall erfasst hat.

9. Verfahren zum Erkennen eines Herdtyps, **dadurch gekennzeichnet, daß** es umfaßt:
- Empfangen (502) von Hochfrequenzstörungen in der Nähe eines Herdes und Bilden entsprechender Empfangsdaten,
- Erkennen (503) einer oder mehrerer regelmäßiger Änderungen in den Empfangsdaten, und
- Schließen (503) aus den erkannten regelmäßigen Änderungen, daß der Herd ein Induktionsherd ist.

10. Verfahren nach Anspruch 9, **dadurch gekennzeichnet, dass** es den Empfang (502) von sich drahtlos ausbreitenden Hochfrequenzstörungen mit einer primären Resonanzfrequenz von einigen Dutzend oder Hunderten Kilohertz, vorzugsweise 30 - 120 kHz, umfasst.

11. Verfahren nach Anspruch 9 oder 10, **dadurch gekennzeichnet, dass** es umfasst, aus den erkannten regelmäßigen Änderungen zu schließen (503), dass es sich bei dem Herd um einen Induktionsherd handelt, wenn eine bestimmte regelmäßige Änderung gleichzeitig mit einem plötzlichen Temperaturanstieg oder - abfall auftritt, der von Sensoren einer Herdschutzvorrichtung erfasst wird.

12. Verfahren nach einem der Ansprüche 9 bis 11, **dadurch gekennzeichnet, dass**, wenn erkannt wird (503), dass es sich bei dem Herd um einen Induktionsherd handelt, mindestens eine induktionsherdspezifische Einstellung aktiviert wird (504), um den Betrieb der Herdüberwachung bzw. des Herdschutzes anzupassen.

13. Verfahren nach Anspruch 12, **dadurch gekennzeichnet, dass** die Einstellung mindestens eine der folgenden ist: Ausnahmesituation in Abhängigkeit vom Temperaturanstieg, abgestimmt auf den Betrieb eines Induktionsherdes; Verzögerung zwischen der Feststellung einer Ausnahmesituation und dem Abschalten eines Teils des Herdes.

## Revendications

1. Agencement de protection de table de cuisson, comprenant
- des capteurs (102, 103) pour détecter des événements sur une table de cuisson et pour fournir des données de détection, et
- un composant de traitement programmable (204) pour analyser les données de détection et pour fournir des données de situation exceptionnelle en réponse au fait que les données de détection indiquent une situation exceptionnelle définie dans la programmation du composant de traitement (204) ;
**caractérisé en ce que**
- l'agencement de protection de table de cuisson comprend un récepteur (202) connecté au composant de traitement (204) et agencé pour recevoir un brouillage radiofréquence et pour fournir des données de réception correspondantes,
- le composant de traitement (204) est agencé pour reconnaître des changements réguliers dans lesdites données de réception et pour tirer, sur la base des changements réguliers reconnus,
une conclusion selon laquelle la table de cuisson est une table de cuisson à induction.

2. Agencement de protection de table de cuisson selon la revendication 1, **caractérisé en ce que** ledit récepteur (202) est agencé pour recevoir sans fil un brouillage radiofréquence propagé.

3. Agencement de protection de table de cuisson selon la revendication 2, **caractérisé en ce que** le récepteur comprend un circuit oscillant (301, 302, 303) avec une fréquence de résonance principale de plusieurs dizaines ou centaines de kilohertz, de manière davantage préférée de 30 à 120 kHz.

4. Agencement de protection de table de cuisson selon la revendication 3, **caractérisé en ce que** ledit circuit oscillant (301, 302, 303) comprend, en tant que composant inductif (301), une bobine à noyau solide agencée sur une carte de circuit imprimé en tant que composant monté en surface.

5. Agencement de protection de table de cuisson selon la revendication 3 ou la revendication 4, **caractérisé en ce qu'**il comprend un couplage de détection (304, 305, 306) connecté au circuit oscillant et comprenant successivement, dans la direction de propagation de signal, un amplificateur (304), un convertisseur A/N (305) et une unité de traitement numérique (306).

6. Agencement de protection de table de cuisson selon la revendication 3 ou la revendication 4, **caractérisé en ce qu'**il comprend un couplage de détection (304, 307, 308, 309, 310) connecté au circuit oscillant et comprenant successivement, dans la direction de propagation de signal, un amplificateur (304), un filtre passe-bande (307), un redresseur et un intégrateur (308, 309, 310).

7. Agencement de protection de table de cuisson selon l'une quelconque des revendications précédentes, **caractérisé en ce que** ledit récepteur (202) est agencé pour recevoir un brouillage radiofréquence conduit en provenance de la ligne d'alimentation en courant de table de cuisson.

8. Agencement de protection de table de cuisson selon l'une quelconque des revendications précédentes, **caractérisé en ce que** le composant de traitement (204) est agencé pour tirer ladite conclusion en réponse à la détection qu'un changement régulier spécifique dans lesdites données de réception se produit simultanément avec les données de détection selon lesquelles au moins l'un desdits capteurs a détecté une augmentation ou une diminution soudaine de la température.

9. Procédé de reconnaissance d'un type de table de cuisson, **caractérisé en ce qu'**il comprend
- la réception (502) d'un brouillage radiofréquence à proximité d'une table de cuisson et la formation de données de réception correspondantes,
- la reconnaissance (503) d'un ou plusieurs changements réguliers dans lesdites données de réception, et
- la conclusion (503), à partir des changements réguliers reconnus, que ladite table de cuisson est une table de cuisson à induction.

10. Procédé selon la revendication 9, **caractérisé en ce qu'**il comprend la réception (502) sans fil d'un brouillage radiofréquence propagé avec une fréquence de résonance principale de plusieurs dizaines ou centaines de kilohertz, de manière davantage préférée de 30 à 120 kHz.

11. Procédé selon la revendication 9 ou la revendication 10, **caractérisé en ce qu'**il comprend la conclusion (503) à partir des changements réguliers reconnus que ladite table de cuisson est une table de cuisson à induction, si un changement régulier spécifique se produit simultanément avec une augmentation ou une diminution soudaine de la température telle que détectée par des capteurs d'un agencement de protection de table de cuisson.

12. Procédé selon l'une quelconque des revendications 9 à 11, **caractérisé en ce que**, lorsqu'il est reconnu (503) que ladite table de cuisson est une table de cuisson à induction, au moins un réglage spécifique à une table de cuisson à induction est activé (504) afin d'ajuster le fonctionnement de la protection de table de cuisson.

13. Procédé selon la revendication 12, **caractérisé en ce que** ledit réglage est au moins l'un des suivants : une situation exceptionnelle dépendant d'une augmentation de la température, correspondant au fonctionnement d'une table de cuisson à induction ; un délai entre la détection d'une situation exceptionnelle et l'extinction d'une certaine partie de la table de cuisson.
